# EUROPEAN PATENT APPLICATION

(11) **EP 4 432 346 A1**
(43) Date of publication of application: **18.09.2024**
(21) Application number: 22892599.6
(22) Date of filing: 26.10.2022
(51) Int. Cl.: H01L 23/40, H05K 7/20

(54) **COVER FOR HEAT GENERATING ELECTRONIC COMPONENT**

(30) Priority: 10.11.2021 JP 2021183699
(71) Applicant: SHIN-ETSU CHEMICAL CO., LTD., Tokyo 1000005 (JP)
(72) Inventor: SAKURAI, Yuuki, Annaka-shi, Gunma 379-0224 (JP); TSUKADA, Junichi, Annaka-shi, Gunma 379-0224 (JP); ENDO, Akihiro, Annaka-shi, Gunma 379-0224 (JP); SUMIYOSHI, Ryoichi, Tokyo 100-0005 (JP)
(74) Representative: Sonnenhauser, Thomas Martin
(86) International application number: PCT/JP2022/040031
(87) International publication number: WO 2023/085099

(57) **Abstract**

The present invention is a cover for a heat generating electronic component including a hollow structure having one or more openings for inserting an electronic circuit component, wherein an inner wall surface of the hollow structure has one or more protrusion portions. Thereby, a cover for a heat generating electronic component that can prevent detachment of the electronic component is provided.

## Description

### TECHNICAL FIELD

The present invention relates to a cover for a heat generating electronic component.

### BACKGROUND ART

In recent years, along with miniaturization and densification of various electronic devices, the heat dissipation problem of heat generating electronic components such as a power transistor that are integrated into the electronic devices has been highlighted.

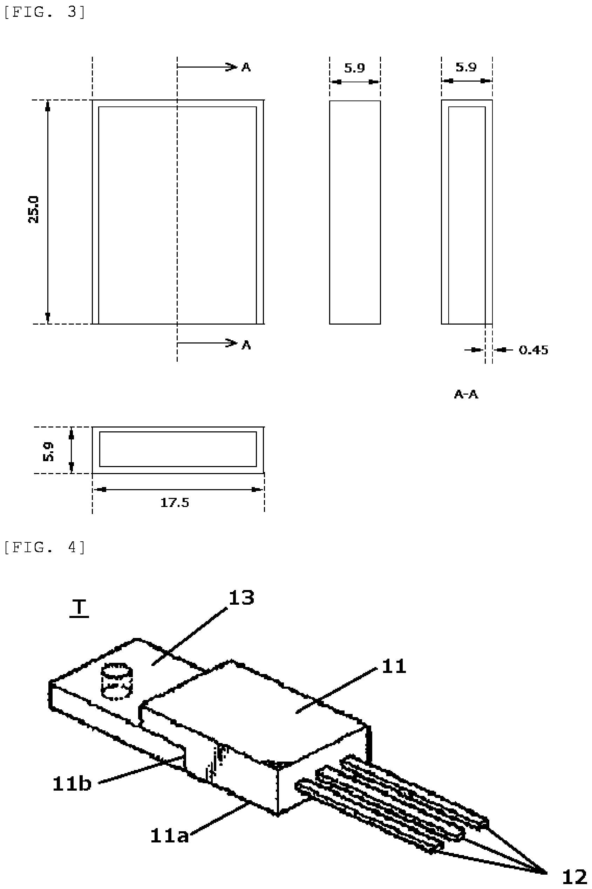

A typical power transistor T has the configuration as shown in FIG. 4. The transistor of FIG. 4 has a transistor body 11 and terminals 12 that protrude from one end surface of the transistor body 11. In addition, the transistor of FIG. 4 includes a flat heat dissipation plate 13 attached to a bottom surface 11a of the power transistor body 11 on the same plane. One end side of this heat dissipation plate is inserted to a cutout 11b formed by cutting off the transistor body 11, and another end side of the plate is placed in the opposite direction from the protrusion direction of the terminals 12. Furthermore, one of the plurality of the terminals 12 is connected to the flat heat dissipation plate 13 inside of the power transistor body 11. Heat generated in the power transistor is transmitted to outside via a thermally conductive material that is sandwiched between the heat dissipation plate 13 and an external heat sink such as a metal chassis.

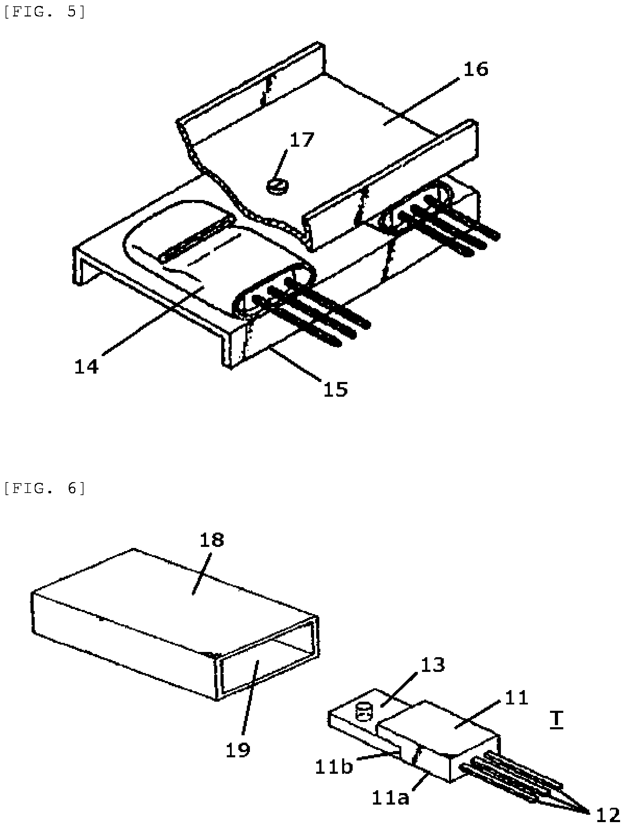

As the thermally conductive material, a liquid material such as heat dissipation grease, or in view of insulation property and assembling ability, a molded product such as a heat dissipation sheet is used. On the other hand, when a heat dissipation material is disposed planarly, a creepage distance for electrical insulation (distance with other electronic component or external heat dissipation plate) is increased. Therefore, a method for molding the thermally conductive material into a tube-shaped cover or a hollow cover having an opening on one side to sterically enclose an electronic component has been conceived (Patent Document 1 and Patent Document 2). The tube-shaped cover is used as shown in FIG. 5. A transistor is inserted into one end of the tube-shaped cover 14, which is sandwiched between two external heat sinks 15 and 16, and secured by a fixing screw 17. Similarly, as shown in FIG. 6, a hollow cover 18 having an opening on one side has a shape having an opening 19 into which a transistor T is inserted. Furthermore, for achieving both heat dissipation and electric insulation more efficiently, a hollow cover having a structure in which thickness of the sides are varied has also been conceived (Patent Document 3). That is, it is a structure in which a thicker side is grounded to a heat dissipation plate side where leakage of current is likely to occur, and the thickness of the opposite side is made thinner, thereby enabling improvement of the heat dissipation.

These thermally conductive molded products have a merit that they can be easily attached to a power transistor because internal dimensions of the products are designed in accordance with a cross section size of the transistor.

However, because of their easy attachability, the thermally conductive molded products may be easily detached or positionally deviated by vibration generated during transfer in the manufacturing process or processing operation until the molded products are secured to an external heat dissipation plate such as a heat sink. Thus, there has been a problem such as deterioration of the operation efficiency or product yield.

### CITATION LIST

### PATENT LITERATURE

Patent Document 1: Japanese Unexamined Utility Model Application Publication No. Sho 57-2666
Patent Document 2: Japanese Examined Utility Model (Registration) Application Publication No. Hei 3-53510
Patent Document 3: JP 2007-115816 A

### SUMMARY OF INVENTION

### TECHNICAL PROBLEM

The present invention was made in view of the above-mentioned circumstances, and has for its object to provide a cover for a heat generating electronic component capable of preventing detachment of an electronic component such as a transistor.

### SOLUTION TO PROBLEM

For solving the above problem, the present invention provides a cover for a heat generating electronic component including a hollow structure having one or more openings for inserting an electronic circuit component, wherein an inner wall surface of the hollow structure has one or more protrusion portions.

The cover for a heat generating electronic component of the present invention as described above can prevent detachment of an electronic component such as a transistor.

In this case, the protrusion portion preferably has a height in the range of 0.1 to 1 mm.

When the height of the protrusion portion is within the above range, it is possible to sufficiently prevent detachment or positional deviation of the cover in producing a substrate, and insertion of a transistor or the like can be performed smoothly.

The cover for a heat generating electronic component of the present invention preferably includes a cured product of a silicone rubber composition containing silicone rubber and a thermally conductive filler.

In such cover, material for forming the cover is a soft and elastic material, and has thermal conductivity and electric insulation. Thus, the cover does not damage an electronic component during insertion, and allows easy insertion of the electronic component. In addition, the cover has sufficient heat resistance such that it can be used even when exposed to a high temperature due to heat generation of the electronic component.

In this case, the cured product of the silicone rubber composition preferably has a thermal conductivity of equal to or more than 0.5 W/m·K.

Such cover can sufficiently promote heat dissipation of a heat generating electronic component such as a power transistor.

Furthermore, the cured product of the silicone rubber composition with a thickness of 0.45 mm preferably has a dielectric breakdown voltage in air of equal to or more than 4.5 W/m·K.

Such cover has good electric insulation, and thus can achieve both heat dissipation and electric insulation more effectively.

The silicone rubber composition is preferably a thermally conductive silicone rubber composition including the following components (A) to (D):
(A) 100 parts by mass of an organopolysiloxane having an average polymerization degree of 3,000 to 10,000;
(B) 10 to 100 parts by mass of an organopolysiloxane having an average polymerization degree of 2 to 2,000, and having an alkenyl group only at both molecular chain terminals;
(C) 500 to 2,700 parts by mass of a thermally conductive filler; and
(D) an effective amount of a curing agent.

The thermally conductive silicone rubber composition as described above is more preferably used as a silicone rubber composition containing a thermally conductive filler that forms a matrix of the cover for a heat generating electronic component of the present invention.

In this case, the component (A) in the silicone rubber composition contains a diorganocyclopolysiloxane having 3 to 10 silicon atoms in a total amount of 500 ppm or less based on a total amount of the component (A) .

The thermally conductive silicone rubber composition as described above is still more preferably used as the silicone rubber composition that forms a matrix of the cover for a heat generating electronic component of the present invention.

### ADVANTAGEOUS EFFECTS OF INVENTION

As described above, according to the present invention, it is possible to provide a cover for a heat generating electronic component that can prevent detachment from an electronic component such as a transistor.

### BRIEF DESCRIPTION OF DRAWINGS

FIG. 1 is a perspective view showing one embodiment of a cover for a heat generating electronic component of the present invention;
FIG. 2 is a view showing a shape of a cover for a heat generating electronic component with a protrusion portion of Example;
FIG. 3 is view showing a shape of a cover for a heat generating electronic component without protrusion portion of Comparative Example;
FIG. 4 is a perspective view showing an example of a power transistor;
FIG. 5 is a perspective view showing an example of use of a tube-shaped cover; and
FIG. 6 is a perspective view showing an example of use of a hollow cover.

### DESCRIPTION OF EMBODIMENTS

The present inventors made intensive investigations to achieve the above object. As a result, they found that a hollow structure having one or more openings, and one or more protrusion portions on its inner wall surface, can be easily attached to a transistor, and also can prevent detachment or positional deviation from the transistor. Thus, the present invention was completed.

That is, the present invention is a cover for a heat generating electronic component, including a hollow structure having one or more openings for inserting an electronic circuit component, wherein an inner wall surface of the hollow structure has one or more protrusion portions.

Hereinafter, the present invention will be described in detail. However, the present invention is not limited thereto.

The cover for a heat generating electronic component of the present invention includes a hollow structure having one or more openings for inserting an electronic circuit component, wherein an inner wall surface of the hollow structure has one or more protrusion portions. The heat generating electronic component is not particularly limited as long as it is an electronic component that generates heat during use, such as a power transistor.

Hereinafter, description will be given by taking a power transistor as an example of the heat generating electronic component.

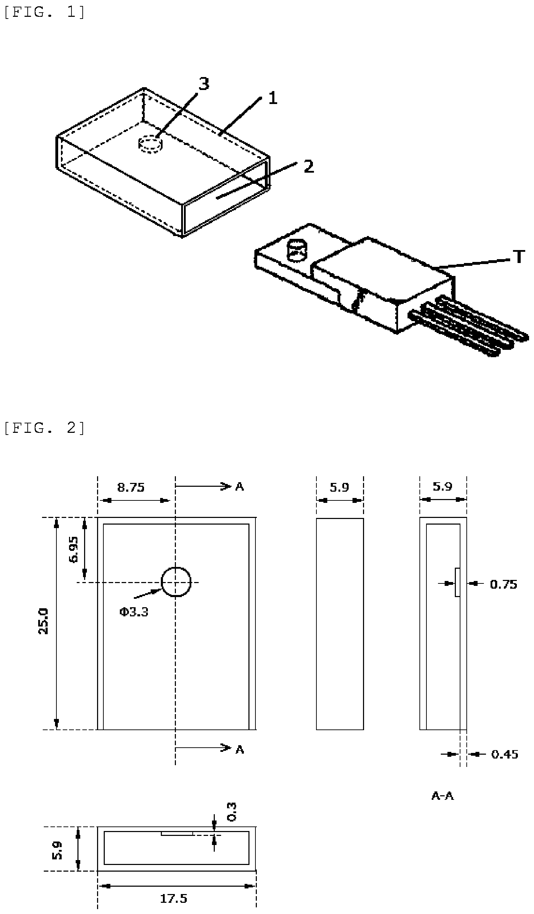

FIG. 1 shows the cover for a heat generating electronic component according to one embodiment of the present invention. This cover is suitably used as a cover for a power transistor as previously shown in FIG. 4, and has an opening 2 at one end of the cover 1 for inserting the power transistor T. Furthermore, the cover for a heat generating electronic component of the present invention has a protrusion portion 3 on the inner wall for preventing detachment from the transistor T after insertion of the transistor.

Herein, when the opening 2 has a shape similar to the cross section of the transistor T, the protrusion portion 3 contacts with the transistor after the insertion. The transistor is pressurized, and thus detachment of the cover 1 can be prevented.

The width of the opening of the cover for a heat generating electronic component may be such that a power transistor can be inserted. Typically, the opening is preferably formed to have the width and height that are substantially the same as the maximum width and the maximum height of the power transistor, or typically 0.1 to 3 mm, preferably 0.3 to 2 mm, and particularly preferably about 0.5 to 1 mm larger than the above maximum width and the maximum height. As described above, by forming the opening (and a hollow portion including the opening) having the width and height that are slightly larger than the maximum width and the maximum height of the power transistor, no redundant space is generated around the transistor when the power transistor attached with the cover of the present invention is disposed in an electronic device. Furthermore, a depth of the cover for a heat generating electronic component is preferably such that at least one-half, more preferably at least four-fifth parts of terminals protrude from the opening 2 when the cover is attached to the power transistor.

The thickness of the cover for a heat generating electronic component of the present invention is preferably 0.1 to 2.0 mm, and more preferably 0.1 to 1.0 mm. When the thickness is equal to or more than 0.1 mm, withstand voltage strength is sufficiently high, for example, when a metal chassis or metal heat dissipation fin is used as an external heat dissipation plate, a short circuit is not caused. Furthermore, sufficient self-holding power is provided, and thus the shape is maintained. On the other hand, when the thickness of a plate part (cover) is equal to or less than 2.0 mm, excellent heat dissipation effect can be obtained.

Number of the protrusion portions on the inner wall surface of the cover for a heat generating electronic component of the present invention is one or more, preferably 1 to 10, and more preferably 1 to 5. When the number of the protrusion portions is equal to or less than 10, space between the cover and power transistor is sufficiently small, and thus thermal conduction is not hindered.

The shape of the protrusion portion in the present invention is not particularly limited. Specific examples include column shape such as a square column, triangular column, and cylindrical column, and pyramid shape such as a square pyramid, triangular pyramid, and cone.

The height of the protrusion portion on the inner wall surface of the cover for a heat generating electronic component of the present invention is preferably in the range of 0.1 to 1 mm, and more preferably 0.2 to 0.5 mm. When the height of the protrusion portion is equal to or more than 0.1 mm, it is possible to sufficiently prevent detachment or positional deviation of the cover in producing a substrate, and when the height is equal to or less than 1 mm, insertion of a transistor is not hindered.

The dimension of the inner wall surface of the cover for a heat generating electronic component of the present invention is preferably larger than the dimension of an electronic component to be covered within the range of 0 to 1.0 mm, and more preferably 0.1 to 0.8 mm. When the dimension of the inner wall surface of the cover for a heat generating electronic component is larger than the dimension of the electronic component by equal to or less than 1.0 mm, the effect of preventing detachment obtained by the protrusion portion can be effectively exerted. When the dimension of the inner wall surface of the cover for a heat generating electronic component is equal to or more than the dimension of the electronic component, preferably larger than the dimension of the electronic component, the electronic component can be easily inserted.

Material for forming the cover for a heat generating electronic component may have thermal conductivity and electric insulation. Moreover, taking damage during insertion or insertion easiness of the electronic component into consideration, a soft and elastic material such as rubber is preferable. Furthermore, there is a possibility that the cover may be exposed to a high temperature due to heat generation of the electronic component, and thus it is preferable to use a silicone rubber composition obtained by adding a thermally conductive filler to silicone rubber.

The silicone rubber composition containing a thermally conductive filler that provides a matrix of the cover for a heat generating electronic component of the present invention is more preferably a thermally conductive silicone rubber composition including the following components (A) to (D):
(A) 100 parts by mass of an organopolysiloxane having an average polymerization degree of 3,000 to 10,000;
(B) 10 to 100 parts by mass of an organopolysiloxane having an average polymerization degree of 2 to 2,000, and having an alkenyl group only at both molecular chain terminals;
(C) 500 to 2,700 parts by mass of a thermally conductive filler; and
(D) an effective amount of a curing agent,
and further, still other components according to need.

### (A) Organopolysiloxane Having Average Polymerization Degree of 3,000 to 10,000

The component (A) serves as a base polymer of the silicone rubber composition, and preferably has an average compositional formula represented by the following formula (1).

RₐSiO_{(4-a)/2} (1)

In the above formula (1), R independently represents a monovalent hydrocarbon group having 1 to 8 carbon atoms, and examples thereof include alkyl groups such as a methyl group, an ethyl group, and a propyl group; alkenyl groups such as a vinyl group and an allyl group; aryl groups such as a phenyl group and a tolyl group; and cycloalkyl groups such as a cyclohexyl group and a cyclopentyl group. Furthermore, groups obtained by substituting part or all of hydrogen atoms directly bonded to carbon atoms in these groups with a halogen atom such as fluorine or chlorine may also be used. Preferred are a methyl group, a phenyl group, a trifluoropropyl group, and a vinyl group. In addition, "a" represents a positive number of 1.85 to 2.10.

The organopolysiloxane preferably has a linear molecular structure, and may partially have a branched structure within the molecule. Further preferably, molecular chain terminals of the organopolysiloxane are blocked with a triorganosilyl group or a hydroxyl group. Examples of the triorganosilyl group include a trimethylsilyl group, a dimethylvinylsilyl group, a trivinylsilyl group, a methylphenylvinylsilyl group, a methyldiphenylsilyl group, a dimethylphenylsilyl group, and a dimethylhydroxysilyl group.

The average polymerization degree of the component (A) is 3,000 to 10,000, and preferably 5,000 to 10,000.

Note that the average polymerization degree referred herein refers to an average polymerization degree obtained from a number average molecular weight determined by gel permeation chromatography (GPC) using tetrahydrofuran (THF) as a solvent and polystyrene as a standard substance.

The component (A) preferably contains a diorganocyclopolysiloxane having 3 to 10 silicon atoms in a total amount of 500 ppm (mass basis) or less based on a total amount of the component (A). The lower the lower limit of the total content is, the more preferable it is. It is not particularly limited, and may be, for example, equal to or more than 10 ppm.

### (B) Alkenyl Group-containing Organopolysiloxane Having Average Polymerization Degree of 2 to 2,000

The component (B) is a component subjected to crosslinking reaction in the silicone rubber composition. The component (B) is an organopolysiloxane having an average polymerization degree of 2 to 2,000 and having alkenyl groups only at both molecular chain terminals. The alkenyl group is preferably an alkenyl group having 2 to 8 carbon atoms, and examples thereof include a vinyl group, an allyl group, a propenyl group, an isopropenyl group, a butenyl group, a hexenyl group, and a cyclohexenyl group. Among them, lower alkenyl groups having 2 to 4 carbon atoms such as a vinyl group and an allyl group are preferred, and a vinyl group is particularly preferred. The organopolysiloxane of the component (B) may be used alone, or two or more organopolysiloxanes having different average polymerization degree may be used in combination.

The average polymerization degree of the component (B) is 2 to 2,000, and preferably 10 to 2,000.

The blending amount of the component (B) is preferably 10 to 100 parts by mass, and more preferably 30 to 70 parts by mass based on 100 parts by mass of the component (A).

### (C) Thermally Conductive Filler

The component (C) is a component used as a filler for imparting thermal conductivity in the silicone rubber composition. The component (C) may be any component as long as it has thermal conductivity, and further preferably, has electric insulation. Examples thereof include, but are not limited to, metal oxides such as alumina, silica, magnesia, red oxide, beryllia, titania, and zirconia; metal nitrides such as aluminum nitride, silicon nitride, and boron nitride; metal hydroxides such as magnesium hydroxide; and substances that are generally used as thermally conductive fillers such as artificial diamond and silicon carbide.

The shape of the thermally conductive filler is not particularly limited, and may be crushed or spherical, according to need.

The average particle diameter (volume average particle diameter) of the thermally conductive filler is preferably 0.1 to 100 µm, more preferably 0.5 to 50 µm, and further preferably 1 to 45 um, as a measurement value determined by a laser diffraction scattering method (micro-track method).

The blending amount of the component (C) is preferably 500 to 2,700 parts by mass, and more preferably 600 to 2,500 parts by mass based on 100 parts by mass of the component (A).

These thermally conductive fillers may be surfacetreated with a surface treatment agent (wetter) such as a silane-based coupling agent or a partial hydrolysate thereof, alkyl alkoxysilane or a partial hydrolysate thereof, organic silazanes, organopolysiloxane oil, and an organopolysiloxane containing a hydrolysable functional group. Examples of the surface treatment agent include a polysiloxane having an alkoxy group or a hydroxy group within the molecule, such as a dimethylpolysiloxane with one end blocked with a trialkoxysilyl group. The bonding state of siloxane units in the polysiloxane may be block or random. The thermally conductive filler itself may be treated in advance, or the treatment may be performed when the component (A), organopolysiloxane of the component (B), and (C) thermally conductive filler are mixed.

### (D) Curing Agent

The component (D) is a component for curing the silicone rubber composition. The curing agent is appropriately selected according to the crosslinking reaction mechanism of the composition.

In the case of radical crosslinking reaction, an organic peroxide is used. Specific examples thereof include benzoyl peroxide, monochlorobenzoyl peroxide, bis 2,4-dichlorobenzoyl peroxide, o-methylbenzoyl peroxide, p-methylbenzoyl peroxide, di(t-butyl) perbenzoate, dicumyl peroxide, 2,5-dimethyl-2,5-bis(t-butyl peroxy)hexane, and di(t-butyl)peroxide. The organic peroxide is preferably added in an amount of 0.1 to 10 parts by mass, and particularly preferably 0.2 to 5 parts by mass, based on 100 parts by mass of total organopolysiloxane in the component (A) and component (B) .

In the case of addition crosslinking reaction, an organohydrogen siloxane having two or more hydrogen atoms directly bonded to silicon atoms per molecule, and as a catalyst, an effective amount (catalytic amount) of a platinum group element (preferably platinum) or a compound thereof are used. In this case, it is necessary that the organopolysiloxane contains two or more alkenyl groups per molecule. The organohydrogen polysiloxane is preferably added in such an amount that the amount of hydrogen atoms directly bonded to silicon atoms are preferably 0.5 to 5 times, particularly preferably 0.6 to 3 times as large as the amount of alkenyl group contained in the components (A) and component (B).

Furthermore, in the case of condensation crosslinking reaction, hydrolysable silane or siloxane containing two or more, preferably three or more hydrolysable groups such as an alkoxy group, an acetoxy group, and an oxime group per molecule is used as a crosslinking agent (curing agent). The blending amount of the crosslinking agent is 1 to 20 parts by mass, and particularly 2 to 10 parts by mass based on 100 parts by mass of total organopolysiloxane in the component (A) and the component (B). In addition, as the catalyst, an organometallic compound such as Sn, Ti, Fe, or Co is preferably used. In this case, it is necessary that both molecular chain terminals of the organopolysiloxane are blocked with a hydroxyl group or an alkoxy group.

The blending amount of the curing agent (crosslinking agent) may be an effective amount, and may be appropriately adjusted in accordance with the species and blending ratio of other components. In addition, radical reaction using ultraviolet irradiation or electron beam irradiation may also be used, but the curing method is not limited thereto.

### Other Components

The silicone rubber composition of the present invention may also contain the surface treatment agent described above, and still other components according to need. For example, optional components including a heat resistance improver such as iron oxide and cerium oxide; a viscosity modifier such as silica; a colorant; and an internal mold release agent such as methyl phenyl polysiloxane may be blended.

### Production of Silicone Rubber Composition

The silicone rubber composition can be produced by mixing the above components. The production method is not particularly limited, and a known method can be used. For example, the silicone rubber composition can be produced as follows.
(1) The components (A) to (C) described above, and optional components of the surface treatment agent and internal mold release agent are placed in a 5 L heat treatment kneader, and mixed at 25°C to 40°C for 30 minutes. Then, the inside of the kneader is heated. After confirming that the composition temperature reached 170°C, heating and stirring are further performed for 2 hours.
(2) After the heating and stirring, the composition is cooled to around room temperature (25°C), and a kneaded compound is taken out. Then, by using a twin roll, a curing agent is added to the compound, and the mixture is kneaded to obtain a thermally conductive silicone rubber composition.

### Molding Method (Method for Producing Cover for Heat Generating Electronic Component)

Molding of the cover for a heat generating electronic component of the present invention is preferably performed by die molding, in which the silicone rubber composition is poured into a molding die and heat-cured. In particular, the molding is preferably performed by transfer molding, in which a material softened by heat is poured into a mold and cured, in view of dimension accuracy and mass productivity of the molded product. When the molding is performed by transfer molding, the pressure for injecting the silicone rubber composition into the die is preferably 100 to 300 kgf/cm². When the injection pressure is equal to or less than 300 kgf/cm², an oily component and the thermally conductive filler in the silicone rubber composition are not separated. And when the injection pressure is equal to or more than 100 kgf/cm², injection does not take a long time, and thus curing of the material does not proceed. Furthermore, for removing the molded cover for a heat generating electronic component from the die, it is effective to apply or spray a surfactant on the surface of die.

### Cured Product of Silicone Rubber Composition

The cover for a heat generating electronic component of the present invention, preferably, is formed from a cured product of a silicone rubber composition containing silicone rubber and a thermally conductive filler.

In such cover, material for forming the cover is a soft and elastic material, and has thermal conductivity and electric insulation. Thus, the cover does not damage an electronic component during insertion, and allows easy insertion of the electronic component. In addition, the cover has sufficient heat resistance such that it can be used even when exposed to a high temperature due to heat generation of the electronic component.

The cured product of the silicone rubber composition preferably has a thermal conductivity of equal to or more than 0.5 W/m·K. The cured product as above can sufficiently promote heat dissipation of a heat generating electronic component such as a power transistor. The higher the upper limit of the thermal conductivity is, the more preferable it is. It is not particularly limited, and may be, for example, equal to or less than 10 W/m·K.

In the present invention, the thermal conductivity may be measured, for example, by a hot disk method in accordance with ISO 22007-2 at 25°C using TPA-501 (manufactured by KYOTO ELECTRONICS MANUFACTURING CO., LTD.) .

Furthermore, the cured product of the silicone rubber composition with a thickness of 0.45 mm preferably has dielectric breakdown voltage in air of equal to or more than 4.5 kV. The cured product as above has good electric insulation, and thus can achieve both heat dissipation and electric insulation more effectively. The higher the upper limit of the dielectric breakdown voltage is, the more preferable it is. It is not particularly limited, and may be, for example, equal to or less than 10 kV.

Measurement of the dielectric breakdown in air of the cured product (molded product) with a thickness of 0.45 mm may be performed by attaching an electrode to the object to be measured, applying 4.5 kV voltage for 10 seconds in air to determine whether there is leakage current.

### EXAMPLE

Hereinafter, the present invention will be specifically described with reference to Example and Comparative Example. However, the present invention is not limited to the following Example.

### Preparation of Thermally Conductive Silicone Composition

(1) The components (A) to (C) shown below, and optional components (E) and (F) were placed in a 5 L heat treatment kneader (manufactured by INOUE MFG., INC.), and mixed at 25 to 40°C for 30 minutes. Then, the inside of the kneader was heated. After confirming that the composition temperature reached 170°C, heating and stirring were further performed for 2 hours.

### Component (A)

One hundred parts by mass of a dimethylpolysiloxane having vinyl groups at both terminals and having an average polymerization degree of 8,000:

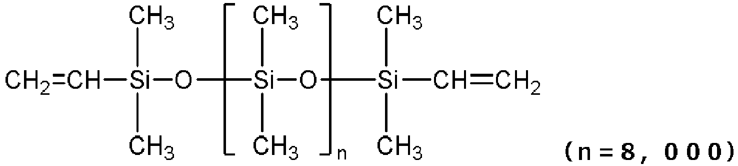

### Component (B)

(B-1) 27 parts by mass of a dimethylpolysiloxane having vinyl groups at both terminals and having an average polymerization degree of 500:

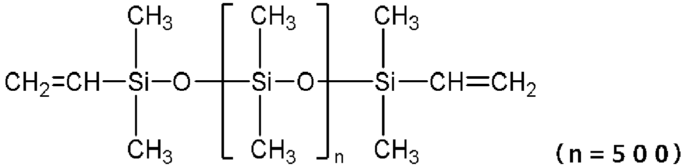

(B-2) 15 parts by mass of a dimethylpolysiloxane having vinyl groups at both terminals and having an average polymerization degree of 1,600:

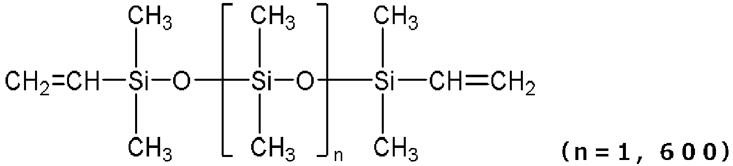

### Component (C)

### Thermally Conductive Filler:

(C-1) 1080 parts by mass of crashed alumina having an average particle diameter of 1 um
(C-2) 385 parts by mass of spherical alumina having an average particle diameter of 1 um
(C-3) 462 parts by mass of spherical alumina having an average particle diameter of 10 um
(C-4) 231 parts by mass of spherical alumina having an average particle diameter of 45 um
(The average particle diameter is a volume average particle diameter measured by the laser diffraction scattering method.)

### Component (E)

Nineteen parts by mass of a dimethylpolysiloxane with one end blocked with a trialkoxysilyl group represented by the following formula (E-1) as a surface treatment agent (wetter component) of the component (C); and

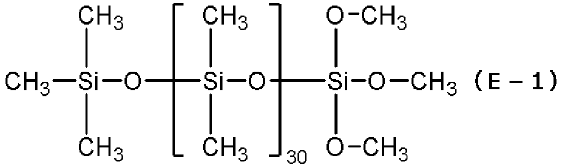

6 parts by mass of a vinyl-containing dimethylpolysiloxane represented by the following formula (E-2); 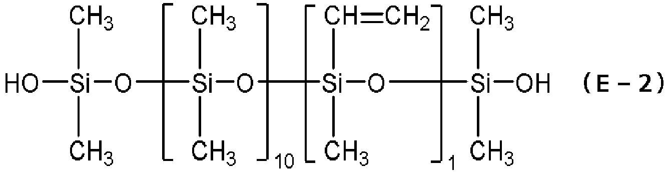 wherein the bonding state of the siloxane units may be block or random.

### Component (F)

Seven parts by mass of a methylphenyl polysiloxane represented by the following formula as an internal mold release agent; 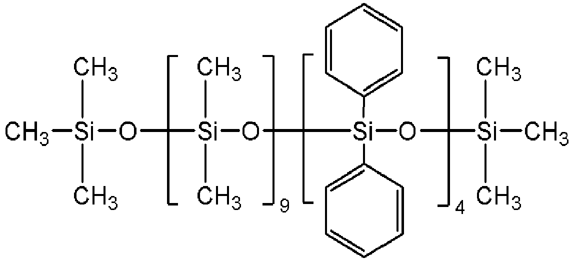 wherein the bonding state of the siloxane units may be block or random.

(2) After the heating and stirring, the composition was cooled to around room temperature (25°C), and a kneaded compound was taken out. Then, by using a twin roll (manufactured by Daishin Kikai Co., Ltd.), the following component (D) was added and kneaded as a curing agent with the compound to obtain a thermally conductive silicone rubber composition.

(D) 0.8 parts by mass of an organic peroxide represented by the following formula:

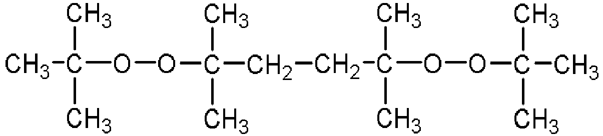

### Thermal Conductivity Measurement

The obtained thermally conductive silicone rubber composition was poured into a flat die with a depth of 6 mm, and press cured for 10 minutes using a high-pressure pressing machine (manufactured by Shoji Iron Works Co., Ltd.) at 165°C and 100 kgf/cm² to produce a sheet with a thickness of 6 mm.

Using two 6 mm thickness sheets thus produced, the thermal conductivity was measured by a hot disk method in accordance with ISO 22007-2 at 25°C using TPA-501 (manufactured by KYOTO ELECTRONICS MANUFACTURING CO., LTD.). As a result, the thermal conductivity was 2.8 W/m·K.

### Molding of Cover for Heat Generating Electronic Component

The thermally conductive silicone rubber composition after kneading was molded by heat pressing at 165°C and 100 kgf/cm² for 10 minutes using a transfer molding machine including a piston, pot, middle mold, and lower mold (manufactured by PRC Co., Ltd.). After the molded product was removed from the die, secondary vulcanization was performed at 150°C for 1 hour, thereby producing a cover for a heat generating electronic component. The shape of the cover for a heat generating electronic component is as shown in the following Example 1 and Comparative Example 1.

### Example 1

A thermally conductive silicone rubber composition was molded as described above, thereby producing a cover for a heat generating electronic component in the shape as shown in FIG. 2 (with a protrusion portion). In FIG. 2, dimensions (unit: mm) are shown.

### Comparative Example 1

A thermally conductive silicone rubber composition was molded as described above, thereby producing a cover for a heat generating electronic component in the shape as shown in FIG. 3 (without protrusion portion). In FIG. 3, dimensions (unit: mm) are shown.

### Dielectric Breakdown Measurement of Molded Product

To electrodes of 15 mm × 4.5 mm × 20 mm (height) (manufactured by SAFE Corporation), the covers for heat generating electronic components produced in Example 1 and Comparative Example 1 were attached, and voltage of 4.5 kV was applied for 10 seconds to determine whether there was leakage current. The results are shown in Table 1.

### Detachment Test

The molded products produced in the shapes of Example 1 and Comparative Example 1 were attached to a TO-247 transistor (FIG. 4, manufactured by IXYS Corporation, CLA 50 E 1200 HB) secured on a vibration stand with the terminals directed upward. Then, vibration with a swing width of 10 cm in gravity direction and vibration frequency of 10 Hz was applied for 5 minutes to observe whether the products were detached from the transistor. The results are shown in Table 1.

**[Table 1]**

| | Example 1 | Comparative Example 1 |
|---|---|---|
| Transistor type | TO-247 | |
| With or without protrusion structure | With protrusion | Without protrusion |
| Whether there was leakage current when 4.5 kV/10 sec voltage was applied | No leakage current | No leakage current |
| Number of tests | 100 | 100 |
| Number of detachments | 0 | 94 |

As is obvious from the results shown in Table 1, provision of the protrusion portion can prevent detachment of the cover for a heat generating electronic component from the transistor.

It should be noted that the present invention is not limited to the above-described embodiments. The embodiments are just examples, and any examples that substantially have the same configuration and demonstrate the same functions and effects as those in the technical concept disclosed in claims of the present invention are included in the technical scope of the present invention.

## Claims

1. A cover for a heat generating electronic component, comprising a hollow structure having one or more openings for inserting an electronic circuit component, wherein an inner wall surface of the hollow structure has one or more protrusion portions.

2. The cover for a heat generating electronic component according to claim 1, wherein the protrusion portion has a height in a range of 0.1 to 1 mm.

3. The cover for a heat generating electronic component according to claim 1 or 2, comprising a cured product of a silicone rubber composition containing silicone rubber and a thermally conductive filler.

4. The cover for a heat generating electronic component according to claim 3, wherein the cured product of the silicone rubber composition has a thermal conductivity of equal to or more than 0.5 W/m·K.

5. The cover for a heat generating electronic component according to claim 3 or 4, wherein the cured product of the silicone rubber composition with a thickness of 0.45 mm has dielectric breakdown voltage in air of equal to or more than 4.5 kV.

6. The cover for a heat generating electronic component according to any one of claims 3 to 5, wherein the silicone rubber composition is a thermally conductive silicone rubber composition comprising following components (A) to (D):
(A) 100 parts by mass of an organopolysiloxane having an average polymerization degree of 3,000 to 10,000;
(B) 10 to 100 parts by mass of an organopolysiloxane having an average polymerization degree of 2 to 2,000, and having an alkenyl group only at both molecular chain terminals;
(C) 500 to 2,700 parts by mass of a thermally conductive filler; and
(D) an effective amount of a curing agent.

7. The cover for a heat generating electronic component according to claim 6, wherein the component (A) in the silicone rubber composition contains a diorganocyclopolysiloxane having 3 to 10 silicon atoms in a total amount of 500 ppm or less based on a total amount of the component (A).
